Europäisches Patentamt

(19) European Patent Office

Office européen des brevets

(11) Publication number: **0 117 734**
**B1**

(12) **EUROPEAN PATENT SPECIFICATION**

(45) Date of publication of patent specification: **26.04.89**

(21) Application number: **84301196.6**

(22) Date of filing: **24.02.84**

(51) Int. Cl.⁴: **H 01 S 3/23,** H 01 S 3/082, H 01 S 3/103, H 01 S 3/06, G 02 F 3/00

(54) **Multicavity optical device and applications thereof.**

(30) Priority: **25.02.83 US 469800**
**13.05.83 US 494275**
**25.02.83 US 469891**
**08.04.83 US 482964**

(43) Date of publication of application:
**05.09.84 Bulletin 84/36**

(45) Publication of the grant of the patent:
**26.04.89 Bulletin 89/17**

(84) Designated Contracting States:
**BE DE FR GB IT NL SE**

(56) References cited:
**DE-A-2 737 345**
**DE-A-3 006 949**
**FR-A-1 429 704**
**FR-A-2 306 551**
**US-A-3 303 431**
**US-A-4 284 963**

(73) Proprietor: **AMERICAN TELEPHONE AND TELEGRAPH COMPANY**
**550 Madison Avenue**
**New York, NY 10022 (US)**

(72) Inventor: **Olsson, Nils Anders**
**256 Springfield Avenue**
**Summit New Jersey 07901 (US)**
Inventor: **Tsang, Won-Tien**
**78 Woodcrest Drive**
**New Providence New Jersey 07974 (US)**

(74) Representative: **Watts, Christopher Malcolm Kelway, Dr. et al**
**Western Electric Company Limited**
**5 Mornington Road**
**Woodford Green Essex, IG8 0TU (GB)**

Courier Press, Leamington Spa, England.

## Description

Technical field

This invention relates generally to semiconductor optical devices and particularly to such devices having optically-coupled cavities that, for example, yield output of a single longitudinal mode when the cavities are appropriately biased and of a wavelength that may be varied by adjusting the current through at least one of the cavities. The invention also relates to means for stabilizing the light output of such devices, and further describes the use of such devices in a novel communications system.

Background of the invention

Optical communications systems typically use light sources and photodetectors that are optically coupled to each other by means of a glass transmission line referred to as an optical fiber. The light source generally used in such systems comprises a semiconductor laser diode which has an active layer, i.e., the region in which electron-hole recombination occurs, of relatively small dimensions perpendicular to the direction of radiation emission and which is generally in the form of a stripe.

For high data rate communications systems, narrow spectral output corresponding to single mode operation of the light source is desirable as this minimizes various problems resulting from the pulse broadening associated with the material dispersion of the glass fiber. In practice, single mode output from a multi mode light source is obtained by somehow suppressing all modes ("secondary modes") other than a single, desired mode (the "primary mode").

One known approach to obtaining single wavelength operation from semiconductor laser diodes is the use of a coupled cavity configuration as set out in the preamble of claim 1. Devices of this type are described by Coldren et al in Applied Physics Letters, pp. 315—317, March 1981 and in Electronics Letters, 18, pp. 901—902, October 14, 1982. In the Coldren devices, a groove is etched into the crystal of a laser diode to provide two separate and spaced apart optical cavities, the two cavities being optically coupled together through the walls of the etched groove. Such devices display basically single mode operation, but the intensity ratio between the primary (desired) mode and the suppressed, secondary (undesired) modes is relatively low. This is one problem of such prior art coupled cavity devices.

Another problem is that the wavelength of the primary mode of such devices tends not to be stable with age and variations in operating parameters, particularly temperature.

FR—A—2306551 discloses a laser which combines the narrow line width associated with a good quality semiconductor laser with a fast modulation rate. Two semiconductor laser diodes are placed in tandem. The first, which is of high optical quality, produces radiation of narrow line width, while the second, which is of lower optical quality, acts as an amplifier locking on to the optical frequency of the first. The modulation is applied to the second only. It is important, in order for this device to operate as desired, that the second laser diode does not influence the oscillation of the first. For example an optical isolator may be used to prevent any light from the second reaching the first. The line width of the device is the line width of the first laser diode.

US—A—3303431 discloses an optical logic device capable of producing an AND operation. Two laser diodes are placed in tandem. The combined device lases when a certain threshold current is applied to both diodes, but not when it is applied to either one alone.

Summary of the invention

With the device as claimed in claim 1 improved mode selectivity can be obtained.

In use of the device, a feedback arrangement can be used which utilizes a characteristic of the light output, e.g., the nonlinear nature of the light output, to stabilize the output from the device.

Devices according to the invention can also be used in a novel shift keying optical communication system.

Brief description of the drawing

Figure 1 is a perspective view of a device according to the invention;

Figure 2 is a cross-sectional view through the active layer of a device according to this invention;

Figures 3—6 illustrate steps in the fabrication of devices according to this invention;

Figures 7—9 show the allowed Fabry-Perot modes for both the individual diodes and the optically coupled cavity for devices according to this invention;

Figure 10 shows the gain profile of the laser medium and the resultant laser spectrum for a device according to this invention;

Figure 11 shows the laser output intensity as a function of wavelength with the wavelength being plotted horizontally and the optical output intensity being plotted vertically with the different curves showing the output for different elapsed times in nanoseconds;

Figure 12 shows the frequency tuning obtained for a device according to this invention with the wavelength being plotted horizontally and the output being plotted vertically with the different curves showing the output for different currents through the second section of the laser as indicated on the lines:

Figures 13—14 illustrates embodiments suitable for optical logic devices;

Figure 15 is a schematic representation of yet another embodiment of this invention;

Figure 16 is a schematic representation of an embodiment of this invention having two diode sections placed in an external cavity;

Figure 17 is a schematic representation of yet another embodiment of this invention having three diodes sections placed in an external cavity;

Figure 18 plots the modulator current horizontally in units of mA versus the output power vertically in arbitrary units for a cleaved-coupled cavity laser;

Figure 19 plots the modulator currrent horizontally in units of mA versus the derivative of the light output vertically, for a cleaved-coupled cavity laser;

Figure 20 is a schematic representation of a light transmitter unit according to one feature of this invention;

Figure 21 shows single mode operating ranges for a cleaved-coupled cavity laser without stabilization (dotted lines) and with stabilization (dashed lines) for variations in both temperature and laser diode drive current;

Figure 22 is a schematic representation of a frequency shift keying optical communications system according to one feature of this invention; and

Figure 23 is a representation of a repeater unit useful in the system depicted in Figure 22.

Detailed description

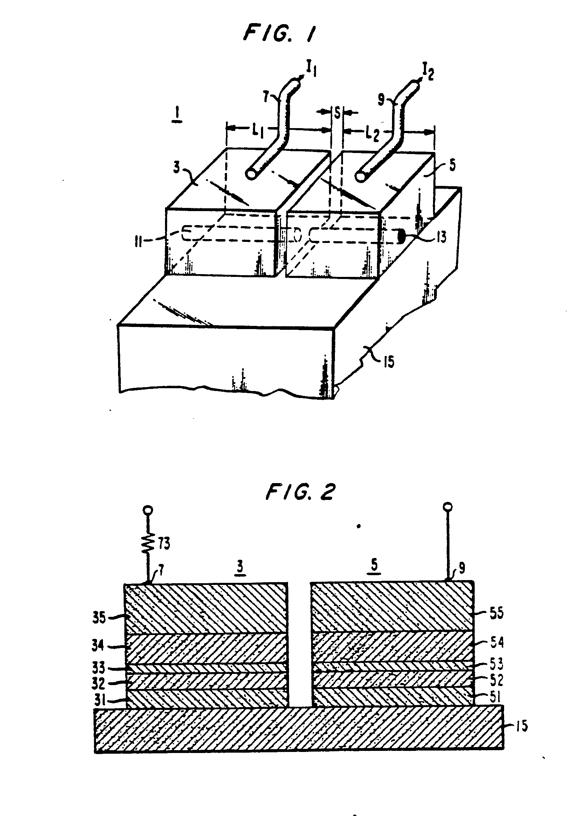

One embodiment of this invention is depicted in a perspective view in Figure 1. The device, indicated generally as 1, comprises a first laser diode section 3, a second laser diode section 5, and electrical contacts 7 and 9 to sections 3 and 5, respectively. The active layers of sections 3 and 5 are indicated as 11 and 13, respectively. The diode sections are disposed on substrate 15. The diode sections 3 and 5 have lengths $L_1$ and $L_2$, respectively, and are separated from each other by a distance, S. All four end facets of the two diode sections in the embodiment depicted are cleaved surfaces and are essentially parallel to each other, the cleaved surfaces comprising "mirrors" as hereinafter defined.

A cross-sectional view of the embodiment of Figure 1 through the active layers is shown in Figure 2. Section 3 is a laser heterostructure that comprises a first layer 31, a first cladding layer 32, active layer 33, second cladding layer 34, and layer 35. Section 5 comprises first layer 51, first cladding layer 52, active layer 53, second cladding layer 54, and layer 55. Further, there is a p-n junction associated with the active layer in each section, i.e., between the active layer and the adjoining layers. The active layer, i.e., the region in which electron-hole recombination occurs, has a first bandgap energy and a first refractive index. The active layers have a width (i.e., a dimension parallel to the substrate 15 and perpendicular to the elongated axis of the layers 11 and 13) through which current is injected that is less than 20 μm to prevent multifilament lasing. The cladding layers have a second bandgap energy which is greater than the first bandgap energy and a second refractive index which is less than the first refractive index. The cladding layers thus provide both carrier and optical confinement for these sections which are index guided. Both sections 3 and 5 are disposed on substrate 15. Sections 3 and 5 are electrically contacted by electrodes 7 and 9, respectively, and there is further a circuit element, such as variable resistance 73, which permits the current through section 3 to be adjusted relative to the current of section 5. The substrate 15 forms a common electrical contact to sections 3 and 5. All the layers are epitaxially grown and are approximately lattice matched to each other and to the substrate. A variable resistance may also be connected to section 5. Further, laser heterostructures other than the one described may also be used and other index guided structures may also be used. Additionally, the layer structures, materials, doping types and concentrations in sections 3 and 5 may differ. There need be only one laser diode in the device. The second or modulator section need not lase during operation and, in some embodiments, may even be incapable of lasing operation.

The active layer (11 or 13) of each diode section forms an optical cavity which extends between the section end mirrors. Also, the active layers of the diode sections are in alignment, i.e., the stripe-shaped layers are positioned essentially colinearly with respect to each other. A result of this is that the two optical cavities are mutually optically coupled through the facing mirrors defining the gap between the sections. The gap spacing, S, is small, being typically less than about 10 μm, but greater than the carrier tunneling distance, thus providing electrical isolation between the sections. This, i.e., the carrier tunneling distance, is approximately 20 nm (200 Angstroms) for electrons in InGaAsP. The term "mirror" is used throughout this description in a manner conventional to experts in the laser art. The term suggests reflection—in this instance, partial reflection—of radiation. A "mirror" need not be silvered or otherwise coated but, as in the instance of an uncoated cleaved surface-air interface, may depend simply on a difference in index of refraction to cause partial reflection.

The compositions of the layers and substrate are not critical, and may be selected from the group consisting of Group III—V and Group II—VI compound semiconductors. These compositions, for example, InGaAsP, permit the wavelength of the emitted radiation to be in the wavelength range between approximately 1.1 μm and approximately 1.7 μm. This is the wavelength range that is presently of greatest interest for optical communications. The device further comprises means for changing the refractive index of at least one section for the purpose of changing the effective optical length of the section. One purpose of this, as hereinafter described, is to increase the ratio of the most intense longitudinal mode to suppressed longitudinal modes. A ratio of 50 or more is thus obtained. The means for changing refractive index comprises, for example, means for adjusting the current or means for adjusting the bias.

As earlier indicated, differently configured multi-cavity devices, made of various materials, can be used; such devices being generally priorly known. However, in accordance with one feature of this invention, the mirror surfaces of the cavities, particularly the mirror surfaces through which the cavities are optically coupled, are cleaved surfaces, i.e., they are formed by known cleaving techniques. An advantage of this is that such cleaved surfaces have better optical characteristics than surfaces prepared by presently known etching techniques, and devices using such cleaved surfaces, in accordance with this invention, can be tuned, as hereinafter described, to have significantly greater primary to secondary mode intensity ratios as compared with prior known multi-cavity devices.

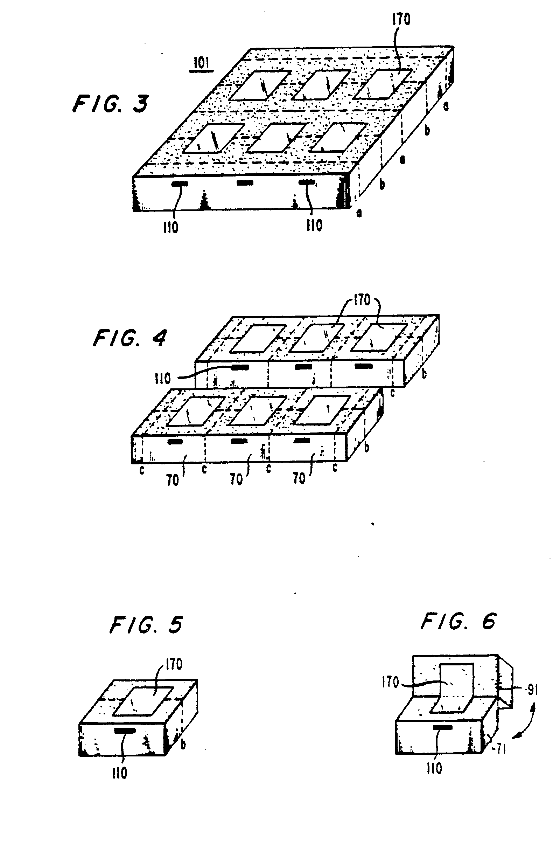

Figures 3—6 illustrate an exemplary method for forming devices comprising coupled cavities from a unitary structure according to this invention. Figure 3 shows a standard semiconductor laser wafer, indicated generally as 101, having a plurality of active layers or stripes 110 and a plurality of gold pads 170 which are formed by, for example, electroplating or evaporation. Other prior known arrangements of the active layers and adjacent layers, referred to, for example, as buried heterostructures, buried crescent heterostructures, ridge waveguide lasers, or the like, can be used. The desired layers may be grown on a substrate by known growth techniques, such as molecular beam or liquid phase epitaxy. Although present, neither the substrate nor various one of the layers (see Figure 2) are shown in Figures 3—6. The isolated thick gold pads should preferably be approximately the same size as the individual diodes to be fabricated and can be electroplated onto either side of the wafer depending upon how the finished device is to be assembled into a package. Metals other than gold may be used if they adhere to the wafer and may be plastically deformed. Known cleaving procedures are now applied at the positions indicated as *a* and *b*. At the positions indicated as *a*, the wafer sections separate from each other as these sections are not contacted by the gold pads. However, at the positions indicated as *b*, the presence of the gold pad holds the adjacent cleaved sections together. The lengths ab and ba are not critical and can be selected as desired. Figure 4 illustrates the resulting structures. The individual pairs 70 of diodes, which are still held together by the gold pads, are now separated from each other by sawing or scribing along positions *c*. The resulting structure of a single pair of laser diode sections is illustrated in Figure 5 which shows two precisely self-aligned and extremely closely optically coupled (Fabry-Perot) cavities. The mirrors of the cavities are formed by the cleaved surfaces.

A typical separation of the coupled cavities is approximately 1 μm. If a larger separation for the pad linked structure is desired, it can be easily obtained by, for example, moving the two Fabry-Perot diodes with respect to each other using the gold pad as the hinge, thereby physically deforming (stretching) the pad. This process is illustrated in Figure 6 with the arrow illustrating the relative movement of the two cavities 71 and 91. The precise separation is not critical but it should be greater than the carrier tunneling distance and less than approximately 10 μm. Of course, the last movement should place the mirror faces parallel or approximately parallel to each other so that the active stripes are aligned with respect to each other. The mirror faces need not be precisely parallel to each other as the angular distribution of the emitted radiation is sufficiently broad to optically couple the cavities. However, the faces should not contact each other, as electrical isolation between the sections is desired. Further, the Fabry-Perot diodes may be slightly twisted with respect to each other with the active stripes forming the twist axis. This twist has a transverse mode filtering effect, i.e., certain transverse modes can be suppressed.

To complete the device, the two Fabry-Perot diodes hinged together by the gold pad are bonded, using, e.g., indium, to a heat sink, such as gold plated copper. Separate electrical connections are made to each diode.

Use of the gold bonding pads is not essential. For example, the laser diode sections may be formed by cleaving a standard wafer without bonding pads and then positioning the diodes with respect to each other on the heat sink and bonding. However, the use of the gold pads facilitates relatively accurate positioning of the active stripes with respect to each other.

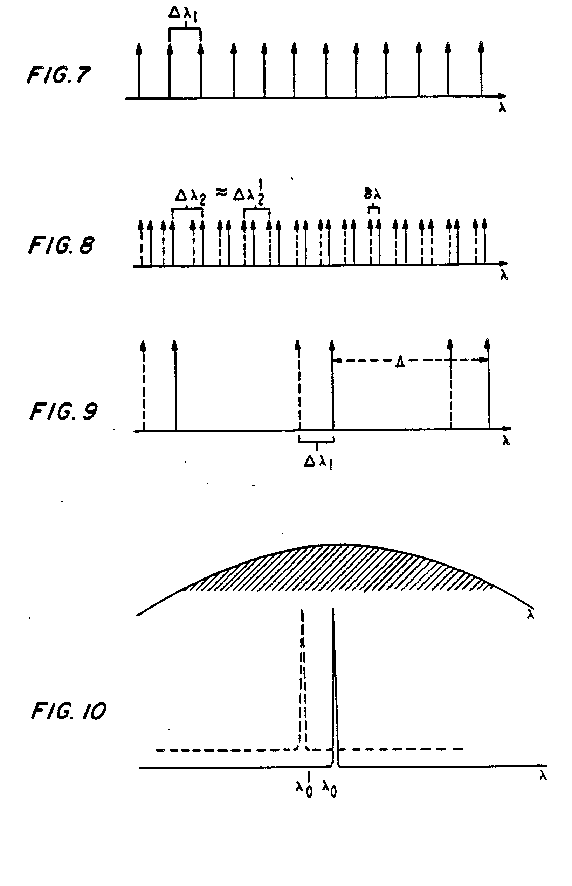

The operation of devices according to this invention may be better understood by reference to Figures 7—10. The allowed Fabry-Perot modes are shown for laser diode sections 1 and 2 by the solid lines in Figures 7 and 8, respectively. (At this point in the discussion, the dashed lines can be ignored.) The propagating modes in each active stripe can have a different effective refractive index $N_{eff}$ even though the stripes have the same geometric shape, size, and material composition. This is true because $N_{eff}$ is a function of the carrier density in the active stripe and this is a function of, for example, the injection current below threshold when the junction voltage is not saturated. Thus, varying the current through one section will enable one to adjust the refractive index of the first and second sections relative to each other. The currents through both sections may be separately varied. Of course, the sizes of the stripes in each cavity will generally differ. Thus, the Fabry-Perot mode spacings for the two cavities are different and are given approximately by:

$$\Delta\lambda_1 \approx \lambda^2 4_0 / 2N_{eff1} L_1 \qquad (3)$$

and

$$\Delta\lambda_2 \approx \lambda^2 4_0 / 2N_{eff2} L_2, \qquad (4)$$

for cavities 1 and 2 respectively. The two cavities are mutually optically coupled to each other and those Fabry-Perot modes from each cavity that spectrally coincide will interfere constructively and become the reinforced Fabry-Perot modes of the coupled cavity resonators while the other modes interfere destructively and are suppressed. The allowed modes for the coupled cavity are shown by the solid lines in Figure 9 and are spaced from each other by a spectral separation of $\Delta$. The spectral spacing of the reinforced modes is significantly larger than either of the original individual Fabry-Perot mode spacings as is evident from Figure 9 and depends on the difference between $N_{eff1}L_1$ and $N_{eff2}L_2$. The spacing, $\Delta$, is given by the approximate equation

$$\Delta = \lambda^2 4_0 / 2 \mid N_{eff1}L_1 - N_{eff2}L_2 \mid$$

where it is assumed that $\Delta\lambda_1$ is approximately equal to $\Delta\lambda_2$. Thus, for the reinforced mode near the gain maximum (the gain characteristic being shown by the upper, curved line in Figure 10) the normal gain roll-off is sufficient to suppress the adjacent reinforced modes as is shown in Figure 10 in which the solid bottom line illustrates the resulting laser mode spectrum. Thus, varying the refractive indices of the two sections relative to each other by, for example, varying the currents through the sections, produces single mode operation with the intensity ratio of the primary, i.e., the most intense, mode to the suppressed modes being at least approximately 50. It is to be understood that $N_{eff}$ for one or both sections may be varied to obtain the desired output. Both sections may operate above lasing threshold. Alternatively, the first section may operate above threshold while the second or modulator section operates below threshold.

Of importance to obtaining a high intensity or amplitude primary mode is the fact that the individual modes generated by each cavity, as illustrated in Figures 7 and 8, are quite narrow, i.e., of basically single wavelength. Thus, the modes which interfere constructively are sharply defined and make efficient use of the energy of the combining modes to provide a high intensity, narrow width primary mode. This, it is found, is a direct result of the use of the high optical quality cleaved surfaces in comparison with the prior art (e.g. Coldren et al papers) use of etched surfaces. With etched surfaces (of present optical quality), the cavity individual modes are not as sharply defined and the resulting primary modes are similarly wider and of lower intensity than those obtained from devices according to the present invention.

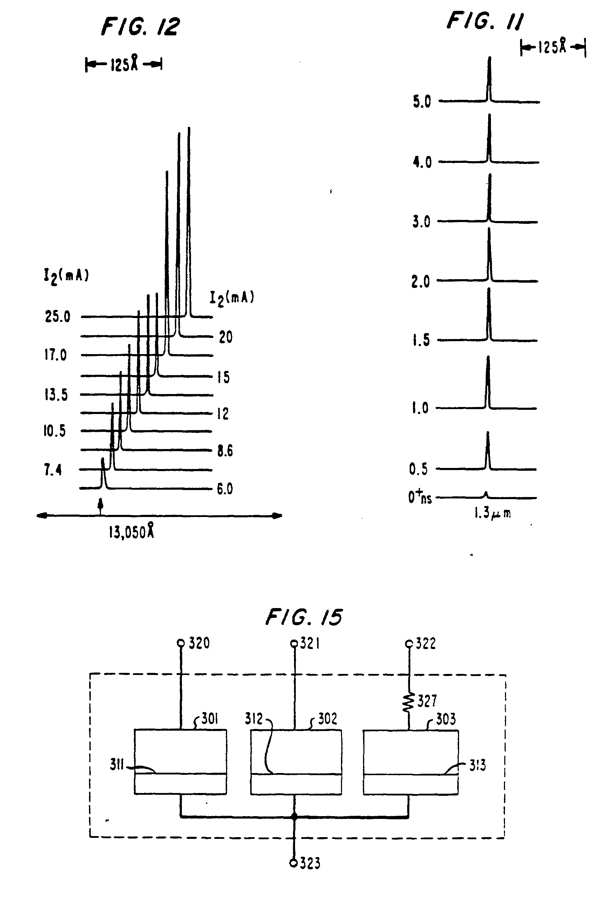

The time resolved transient mode spectrum of an InGaAsP buried crescent laser of the coupled cavity type described is shown in Figure 11 with the wavelength being plotted horizontally and the laser output power intensity vertically in arbitrary units. The spectra are shown for various elapsed times by the individual curves with the elapsed time being indicated on each curve. The lasers were InGaAsP buried crescent lasers such as those described in *Electronics, Letters, 18*, pp. 95—96, 1982. The first diode was pulsed with 28 mA and 20 nsec pulses having a 1 nsec rise time. The optical output for the coupled diodes was detected from the second diode. The elapsed time is measured from the onset of the light pulse resulting from the application of an electrical pulse to the second diode. The first diode can also be biased with direct current or a direct current plus a pulsed current. The second diode may also be biased with a direct current plus a pulsed current. It is apparent from the spectra of Figure 11 that the output power is concentrated in a single longitudinal mode at the onset of the optical pulse and remains in the same longitudinal mode when biased with high speed current pulses.

One can also now understand how relatively wide range direct frequency modulation may be achieved in devices of this invention. Assume that the first laser diode is biased with an injection current level $I_1$ above lasing threshold and it thus acts as a laser. Assume that the second laser diode is biased with a current $I_2$ below threshold and it thus behaves as an etalon 2. Under these operating conditions, the mode spectra are described by the solid line in Figures 7—10. However, if $I_2$ is now increased to a value $I_2$ while $I_1$ is kept constant, the resulting change in the carrier density in the active stripe of the second laser diode section will correspondingly induce a decrease in effective refractive index from $N_{eff2}$ to $N_{eff2}'$. The result is a shift of magnitude $\delta\lambda$ in the modes of laser 2 toward shorter wavelengths. The dashed lines of Figure 8 show the new allowed Fabry-Perot modes of laser 2. As a result of these changes in current and thus refractive index, the Fabry-Perot modes from laser 1 and etalon 2 that originally coincided are now misaligned and the adjacent mode on the shorter wavelength side comes into coincidence and becomes reinforced instead. This is shown by the dashed lines in Figure 9. Thus, a shift by one Fabry-Perot mod spacing, $\Delta\lambda_1$, of the laser toward shorter wavelengths occurs. Since the change in $N_{eff2}$ necessary to shift the next adjacent modes into alignment is small, only a small change in $I_2$ is sufficient to obtain such large frequency modulation. The dashed line in Figure 10 illustrates the resulting laser mode spectrum after $I_2$ is changed.

It is also possible to have the second laser diode biased with a current $I_2$ above threshold and still accomplish frequency shifting by changing $I_2$. This is made possible by designing the second laser diode so that, at lasing threshold and above, the carrier density in the active stripe does not pin at a fixed value. That is, at lasing threshold and above, the additional carriers injected into the active stripe do not all go into producing stimulated emission, but a portion of them still continues to contribute to increasing the carrier density and hence continues to induce changes in the $N_{eff2}$. Such a laser diode, for example, can be produced by having nonuniform material properties for the active stripe.

The size of the frequency shift is greatly enhanced by the necessity to jump at least one discrete Fabry-Perot mode spacing of the first laser. This is approximately 1.5 nm (15 Angstroms) for an approximately 135 $\mu$m InGaAsP cavity operating at approximately 1.3 $\mu$m. It is

approximately 2 nm (20 Angstroms) for an approximately 135 μm InGaAsP cavity operating at approximately 1.5 μm. A further increase in $I_2$ continues to shift the lasing mode of the coupled cavity to the next Fabry-Perot mode of the first laser. This mechanism thus results in a very large frequency tuning rate, for example, 1 nm/mA (10 Angstroms/mA), and a very wide frequency tuning range. The range is typically at least half the spectral width of the gain profile which is greater than approximately 15 nm (150 Angstroms). If the carrier density in the active stripes continues to increase above lasing threshold due to nonpinning of the junction voltage, frequency tuning can be obtained above lasing threshold. In addition to the frequency tuning, it should also be noted that the laser is also operating in a highly stable single longitudinal mode even under the direct high speed direct frequency modulation.

Figure 12 shows the various spectra obtained with different current levels applied to the second or modulator laser diode section. The lasers were InGaAsP buried crescent lasers such as those described in *Electronics Letters, 18,* pp. 95—96, 1982. The wavelength is plotted vertically with the magnitude of the current through the second diode being indicated on each spectrum. The first laser diode was biased with a 48 mA current pulse of 500 nsec duration. This value is approximately 1.3 times the threshold of the diode when no current is applied to the second diode. The current threshold of the second diode alone was 30 mA. The total threshold with both diodes pumped together was approximately 46 mA. The second laser diode was biased with current pulses having amplitudes below threshold, e.g., 30 mA, and a 700 nsec duration. Different current pulse amplitudes produce laser output radiation at different wavelengths as shown in Figure 12. It should be understood that dc currents may be applied to either or to both diodes in addition to the current pulses. It is apparent from the output curves shown in Figure 12 that a frequency shift corresponding to a wavelength shift of approximately 15 nm (150 Angstroms) is obtained as the current through the second laser diode section is varied from 6.0 mA to 25.0 mA.

Devices according to this invention may also be used to perform logic operations optically. The logic devices in this embodiment preferably operate on electrical input signals and produce optical output signals. This is in contrast to optically bistable devices which operate on optical inputs and produce optical outputs.

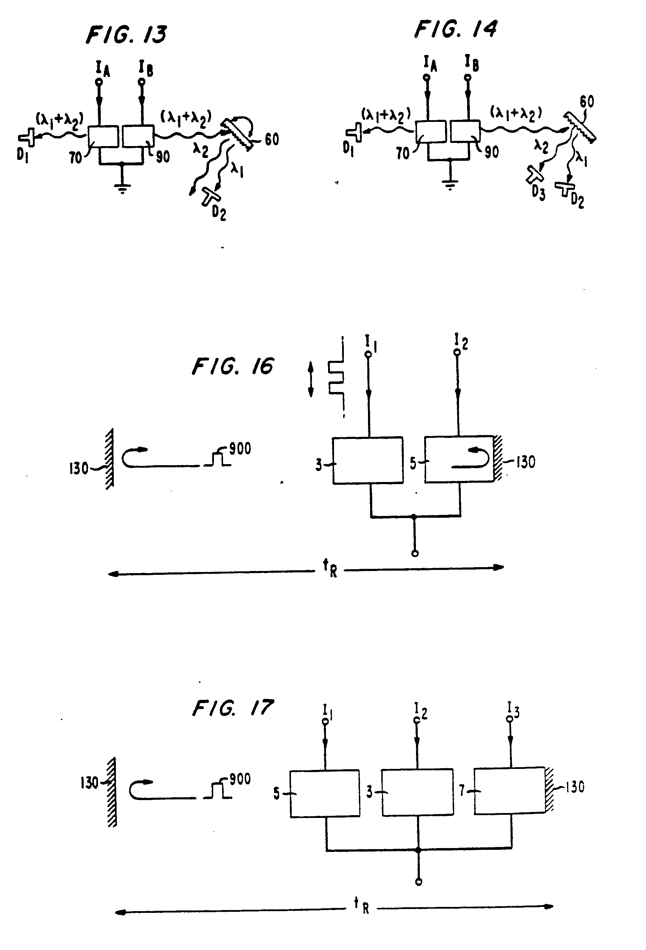

Figures 13 and 14 show schematic representations of embodiments suitable for optical logic circuits. In Figure 13, there is shown a first laser cavity 70, a second laser cavity 90, grating 60, and detectors $D_1$ and $D_2$. The grating 60 is effective, as known, to separate a multi-wavelength radiation into its individual wavelength components. Grating 60 may be rotated as indicated by the arrow so that radiation at a wavelength of either $\lambda_1$ or $\lambda_2$ may be detected by detector $D_2$. Detector $D_1$ is sensitive to radiation of wavelengths $\lambda_1$ and $\lambda_2$.

The embodiment depicted in Figure 14 is similar to that of Figure 13 except that it additionally comprises photodetector $D_3$ and grating 60 does not rotate but directs radiation of wavelengths $\lambda_1$ and $\lambda_2$ to detectors $D_2$ and $D_3$, respectively. Detector $D_2$ and detector $D_3$ are sensitive to radiation of wavelengths $\lambda_1$ and $\lambda_2$, respectively. More than two different wavelengths can also be produced and the detection apparatus modified to detect the additional wavelengths. In both embodiments, cavities 70 and 90 have currents $I_A$ and $I_B$, respectively, flowing through them. The cavities correspond to laser diode sections 3 and 5 of Figures 1 and 2.

The operation of the optical logic circuits may now be understood. Assume that both cavity 70 and cavity 90 have a constant dc bias applied to them. If either cavity 70 or 90 now receives a pulse that raises that cavity above the lasing threshold, an optical output will be detected at detector $D_1$, thereby forming the OR function. When cavities 70 and 90 are pulsed simultaneously above the respective lasing thresholds, radiation of wavelength $\lambda_1$ will be detected at detector $D_2$, thereby forming the AND function. If both cavities are not above threshold, no radiation will be detected at $D_2$. Adding yet another photodetector as shown in Figure 14 permits radiation of wavelength $\lambda_2$ to be detected and thereby permits the exclusive OR operation to be performed. As will be readily appreciated by those skilled in the art, embodiments capable of performing all the logic functions are readily formed by devices according to this invention. These devices rely on the observation that optical beams at different wavelengths can be produced by applying different currents as shown in Figure 12.

Another embodiment of this invention is depicted in Figure 15. This device comprises laser diode sections 301, 302, and 303 which have active stripes 311, 312, and 313, respectively. The sections are contacted electrically by electrodes 320, 321, and 322, respectively. Additionally, there is a common electrical contact 323 to all three sections. Sections 302 and 303 function as previously described, i.e., a coupled cavity producing a single longitudinal mode output, while section 301 functions as a photodetector. This structure can be made as previously described and, as a result, the photodetector is precisely aligned with the active stripe of the laser diodes. This results in extremely efficient optical coupling between the laser diode coupled cavities and permits close monitoring and control of the laser output power. Light from the front (left-hand most) face of the coupled cavities is coupled into the optical fiber for transmission and all light from the back face of the coupled cavities is incident on the photodetector. The resulting signal from the photodetector is used as a feedback to control the injection current into the coupled cavities so that the average power launched into the front face of the fiber is maintained at an approximately constant value as a function of time, i.e., all optical pulses have the same intensity. The diode section operating as the photodiode may be either unbiased or reverse biased.

Several advantages result from this configuration. First, the optical beam from the laser back face is coupled into the photodiode with a high degree of efficiency because of the precise alignment and small separation of the active stripes. Second, the use of index waveguiding in all diode sections and the small separation reduces erroneous photodiode signal feedback due to beam wandering. Third, light coupled into the active stripe of the photodetector is guided by the built-in index waveguiding and, because the absorbing waveguide can be made long for essentially complete absorption, the resulting photon-carrier conversion is very efficient. One could even consider this as a waveguiding and, because the absorbing waveguide can be made long for essentially complete absorption, the resulting photon-carrier conversion is very efficient. One could even consider this as a waveguiding photodetector in contrast to the more conventional broad area of photodiodes which have an absorbing layer of thickness less than approximately 2 µm.

In another embodiment, the coupled cavity device, either a two section or a three section device, may be placed in an external optical cavity and optically aligned with respect to this external optical cavity. Very short optical pulses, typically less than 1 nsec, can be then generated and turned on and off thereby conveying information by adjusting at least one of the currents to one of the laser diode sections.

This is shown in Figure 16. Depicted are diode sections 3 and 5 which are in an external cavity formed by mirrors 130. Currents $I_1$ and $I_2$ pass through diode sections 3 and 5, respectively. Section 3 acts as a laser and section 5 acts as an electrically controlled optical absorber. Section 3 is pulsed electrically, as shown, with a period, $t_R$, in synchronization with the round trip transit time, $t_R$, of the optical pulse 900 in the external cavity. Section 5 is biased below threshold so that the optical absorption level can be varied according to the level of electrical pumping. If section 5 is rapidly pulsed to a high current level, the optical absorption is suddenly decreased and it becomes transparent. This permits a short pulse to leave the cavity and permits information to be conveyed by the mode locked pulses.

The embodiment depicted in Figure 17 is the same as that of Figure 16 with the addition of a third diode section 7. The third diode section acts as a gate for intelligently coding information on the short mode-locked pulses, i.e., a gate that opens or closes the cavity. Section 3 acts as the laser diode and section 5 acts as the electrically controllable saturable optical absorber.

These embodiments may be varied. For example, the external mirror can be a dispersive reflector rather than a nondispersive mirror for single frequency operation and the roles of the several diodes may be interchanged.

Parallel arrays of the coupled cavity configurations described may be easily fabricated. Such an array would be useful in, for example, optical recording systems. Furthermore, the various mirrors may be coated with thin films of a dielectric or metallic nature to alter the reflectivities or spectral selectivity of the mirrors.

One problem associated with lasers in general is the change in output characteristics over time or with changes in operating parameters. One arrangement for stabilizing such output characteristics is now described.

As described previously, the lasers according to this invention can be operated in a mode in which one of the diode sections functions as the source of light and the other section functions merely to control the characteristics of the lasing section, i.e., the "other" section, referred to as the modulator section, does not lase. The stabilization scheme now to be described is intended primarily for such mode of operation, i.e., with the modulator section operating below the lasing threshold. However, the stabilization scheme may also be used with the modulator section operating above lasing threshold because there may be some frequency tuning above threshold due to incomplete pinning of the Fermi level. The stabilization scheme relies on the discovery of nonlinearities, for example, local maxima, in the output power of the laser versus the modulator current.

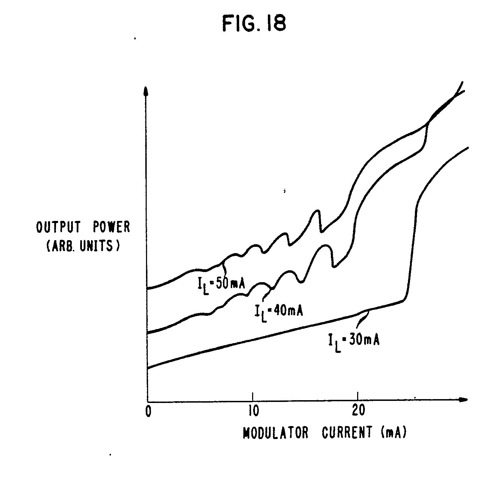

Figure 18 plots the current through the modulator section, horizontally, in units of mA versus the light output, vertically, in arbitrary units from a InGaAsP buried crescent cleaved-coupled cavity laser. The light output is measured from the modulator section (coupled thereto from the laser section). The different curves represent different currents through the laser section with the current being indicated for each curve. The bottom curve, 30 mA through the laser section, represents a current below lasing threshold. As is apparent, the relationship is nonlinear and there are bumps, i.e., local maxima, in the light output power versus current curves which result from wavelength, i.e., frequency, tuning of the cleaved-coupled cavity laser as the modulator current is varied. It was found that the peak of each bump corresponds to the optimum modulator current for each selected longitudinal mode. The optimum modulator current is defined as the current that maximizes the ratio of the most intense longitudinal mode to the second most intense longitudinal mode. It should also be noted that as the current through the laser section varies, the magnitude of the modulator current varies to maintain laser operation at the desired longitudinal mode.

That the local maxima in the light output power versus current curves actually correspond to the optimum modulator current was found by measuring the longitudinal mode discrimination ratio as a function of the first derivative of the output power with respect to the modulator current. The longitudinal mode discrimination ratio is defined here as the ratio of the intensity of the dominant, i.e., most intense, mode to that of the next most intense mode. It was determined that the highest mode ratio coincides with a zero derivative.

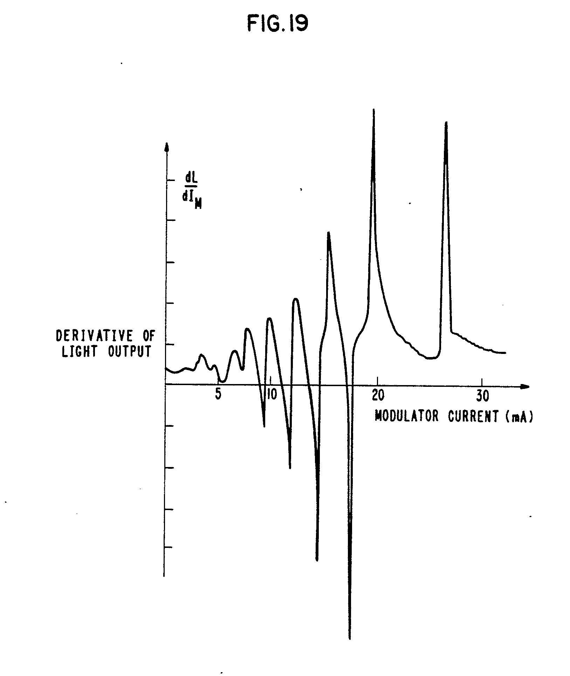

At the optimum modulator current, the curve of output power versus modulator current goes through a local maximum. Therefore, a feedback arrangement that detects the local maxima may be constructed to stabilize the output. For the top two curves depicted, the first derivative of the light output power with respect to the modulator current is zero for the optimum modulator current and it has opposite signs on each side of the zero point. Figure 19 shows the measured first derivative of the output power with respect to the modulator current as a function of the modulator current for a current of 40 mA through the first, i.e., laser, diode section. Therefore, a feeback arrangement using the first derivative of the light output with respect to the modulator current as a signal may be constructed to stabilize the output with respect to frequency by maintaining the first derivative at a value of zero and the output power at a local maximum. That is, the characteristic of the light output used by the feedback arrangement is the first derivative of the light output with respect to the modulator current.

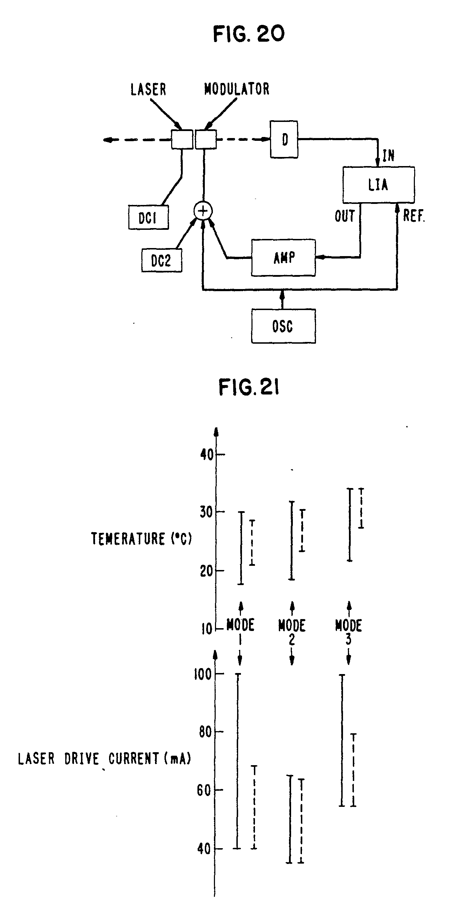

An optical transmitter device comprising a cleaved-coupled cavity laser and a stabilization arrangement to maintain single frequency operation is schematically represented in Figure 20. The device comprises a cleaved-coupled cavity laser having laser and modulator sections indicated as LASER and MODULATOR. The device further comprises direct current sources, DC1 and DC2, to the laser and modulator sections, respectively. Light is emitted from both the laser and modulator sections as indicated by the dashed arrows. A photodetector D detects the light output from the modulator section and generates a signal which goes to a lock-in amplifier LIA. An oscillator, OSC, supplies a current to both the LIA and the modulator section. An output signal from the LIA is amplified by an amplifier, AMP, and applied to the modulator section. Operation and construction of these circuit components are known.

The operation of the device is as follows. A small AC current, approximately 50 microamps, at a frequency of 22 KHz from the oscillator, is applied to the modulator section of the laser. The output power from the modulator section is detected by the photodetector D and the signal from the photodetector goes to the lock-in amplifier LIA. The first derivative of the light output with respect to the current through the modulator section is obtained by detecting the 22 KHz component of the output power with the lock-in amplifier. The means for measuring at least one characteristic comprises the photodetector and lock-in amplifier. After amplification of this signal by the amplifier, the output is fed to the modulator section and the feedback loop is closed. The feedback means comprises the lock-in amplifier, amplifier and oscillator. The loop time constant is approximately 1 msec.

The feedback means was evaluated by measuring the range of single mode operation with respect to both temperature and current through the laser section. The results are demonstrated in Figure 21 where the operating regions are shown as solid (with feedback) and dotted (without feedback) bars. The measurements were made for three different moles at modulator currents of 5 mA, 8 mA, and 11 mA. As can be seen, an approximately 100 percent improvement is obtained in the range over which the laser operates in the single longitudinal mode with respect to both temperature and laser current. The improvement with respect to laser current may be even higher as the laser was not operated at currents greater than 100 mA to avoid possible damage to the laser.

Other characteristics of the light output versus modulator current curve may be used to maintain the output at the desired spectral value. For example, the first derivative may not exist as the light output power may decrease very abruptly, i.e., essentially a step function decrease in intensity, from the local maxima as the modulator current is increased. Additionally, for some modes of operation and for some lasers, it may be desired to have a nonzero value for the first derivative. For these situations, different characteristics may be used by the feedback means. Nonzero first derivative values may also be used for some purposes. That is, the device may operate on the slopes of the bumps of the output power versus modulator current curve. It will also be readily appreciated that a portion of the light output from the laser section may be used rather than the output from the modulator section. It will also be appreciated that the system described maintains the desired spectral output as the current through the laser section is varied.

In one application of the invention, continuous frequency modulation is obtained by superimposing a small modulating current upon the controlled current through the modulator sections. Since the modulator section is operating below threshold, the effective carrier density modulation is obtained with a small modulating current and produces a large frequency excursion for a small variation in current. Additionally, there is only a small amount of unwanted intensity modulation when the modulating current is superimposed on the modulator current that, for example, produces a local maxima in the light output versus modulator current curve.

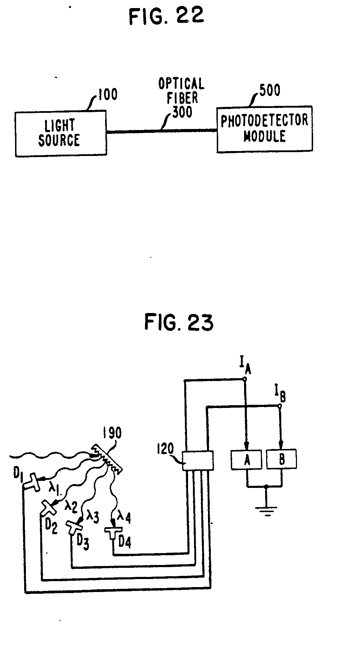

One use for which devices according to the present invention are particularly suited is in a frequency shift keying optical communications system. This is now described with reference to Figures 22 and 23.

Shown in Figure 22 is a cleaved coupled cavity laser which is the light source 100, an optical fiber 300, and a wavelength dispersive photodetector module 500. The light source 100 is tunable to at least two frequencies. The wavelength dispersive photodetector module comprises at least one photodetector and a wavelength dispersive element. The module is thus capable of separate detection of the individual wavelengths. The wavelength dispersive element may be, for example, a grating, interferometer, etc., which diverts the separate wavelengths into different individual photodetectors, within the module, in which the optical pulses are absorbed and corresponding output voltage or current pulses produced at the different individual detectors responsible for detecting the different wavelengths.

The cleaved couple cavity laser is operated as follows in a frequency shift keying communications system. One of the diode sections of the cleaved coupled cavity laser operates as a laser and the second diode section operates under lasing threshold as a frequency modulator. As previously noted, and illustrated in Figure 12, a change in the current applied to the modulator diode produces a shift of the primary mode output of the device. Thus, the means for varying the current through the modulator section comprises means for selecting a desired output frequency from a group of at least two output frequencies. Such frequency shifting can be achieved in less than 1 nanosecond implying that bit rates greater than 1 Gigabit/second can be achieved.

The operation of a two-channel, four-level frequency shift keying system will be better understood by reference to a specific example. Electrical pulses from two channels, A and B, either alone or multiplexed (A+B), may be applied to the modulator diode. The current pulses for channels A and B are of different magnitude. The laser diode has a dc current applied. Because the output lasing wavelength is a function of the current applied to the modulator section of the cleaved coupled cavity laser, the three different current levels that result from multiplexing channels A and B will yield output lasing modes at three different wavelengths. The fourth wavelength is obtained when neither channel A nor B has a pulse. The Table shows the coding and decoding scheme of a four-level two-channel optical frequency shift keying system according to our invention.

TABLE

CODING

| CHANNEL | | |
|---|---|---|
| A | B | |
| 0 | 0 | 0 |
| 1 | 0 | 1 |
| 0 | 1 | 2 |
| 1 | 1 | 3 |

DECODING

A=1+3
B=2+3

Figure 23 depicts a repeater unit useful in the optical frequency shift keying communications system of this invention. The repeater unit comprises a wavelength dispersive element 190, which receives the optical pulse from the previous laser, signal regenerating means 120 and a cleaved coupled cavity laser. The wavelength dispersive element 190, for example, a grating, directs the separate wavelengths, $\lambda_1$, $\lambda_2$, $\lambda_3$, and $\lambda_4$ into the individual photodetectors $D_1$, $D_2$, $D_3$, and $D_4$, respectively. Means 120 receives electrical signals from a plurality of individual photodetectors $D_1$, $D_2$, $D_3$, and $D_4$ and regenerates the electrical current pulses in a known manner. These pulses are then applied to the cleaved coupled cavity laser to produce output at the desired wavelength.

An eight-level, three-channel frequency shift keying system can also be constructed in a similar manner. The laser and photodetector may be optically coupled through air or free space.

**Claims**

1. A semiconductor optical device for generating a single mode radiant output comprising first (3) and second (5) spaced apart index-guided semiconductor diode sections, at least one of said diode sections being a laser diode section, the waveguiding active layers (11, 13; 33, 53) of the diode sections each having a width less than 20 μm and being sufficiently closely coupled to provide enhanced mode selectivity characterised in that said sections are optically coupled together through cleaved mirror surfaces, and means ($l_1$, $l_2$) are provided for adjusting the refractive index of said sections relative to each other.

2. A device as recited in claim 1 including means for changing the wavelength of the radiant output.

3. A device as recited in claim 1 in which said adjusting means comprises means for adjusting the current through said first section.

4. A device as recited in claim 1 further comprising a third cavity section optically coupled to one of the others of said sections.

5. A device as recited in claim 4 in which said third section constitutes a photodetector.

6. A device as recited in claim 5 further comprising means connected between said third section and said first and second sections to control the output from said first and second sections.

7. A device as recited in claim 3 including first means for biasing said first section with a pulsed current and second means for biasing said second section with a pulsed current.

8. A device as recited in claim 7 further comprising photodetector means to detect the optical output from at least one section.

9. A device as recited in claim 8 in which said detector means are wavelength sensitive.

10. A device as recited in claim 1 in which said sections are twisted with respect to each other about an axis formed by said active layers.

11. A device as recited in claim 1 further comprising an external optical cavity, said first and second sections being in and optically aligned with respect to said external optical cavity.

12. A device as recited in claim 1 in which at least one of said mirror surfaces is coated with a thin film.

13. A device as recited in claim 3 in which said means for adjusting comprises means for adjusting bias.

14. A device as recited in claim 3 including means for measuring at least one characteristic of the output from one of said sections with respect to the current through one of said sections; and feedback means using said at least one characteristic to maintain said output at a desired spectral value.

15. A device as recited in claim 14 in which said at least one characteristic comprises the first derivative of the light output intensity with respect to the current through said one section.

16. A device as recited in claim 15 in which said feedback means maintains said first derivative at a value of approximately zero.

17. A device as recited in claim 16 in which said feedback means maintains said value of approximately zero at a local maximum in the light output power versus one section current characteristic curve.

18. A device as recited claim 17 further comprising means for superimposing a modulating current through said one section.

19. A device as recited in claim 14 in which said at least one characteristic comprises the light output intensity.

20. A device as recited in claim 19 in which said feedback means maintains said characteristic at a local maximum in the light output power versus one section current characteristic curve.

**Patentansprüche**

1. Optische Halbleitervorrichtung zum Erzeugen einer Einzelmoden-Ausgangsstrahlung, umfassend erste (3) und zweite (5) beabstandete indexgeführte Halbleiterdiodenabschnitte, wobei wenigstens einer der Diodenabschnitte ein Laserdiodenabschnitt ist und die wellenleitenden aktiven Schichten (11, 13; 33, 53) der Diodenabschnitte je eine Breite von weniger als 20 Mikrometer haben und hinreichend eng gekoppelt sind, um verstärkte Modenselektivität zu erzeugen, dadurch gekennzeichnet, daß
—die Abschnitte über Spalt-Spiegelflächen optisch miteinander gekoppelt sind und Mittel (I₁, I₂) vorgesehen sind, um den Brechungsindex der Abschnitte relativ zueinander einzustellen.

2. Vorrichtung nach Anspruch 1, mit Mitteln zum Ändern der Wellenlänge der Ausgangsstrahlung.

3. Vorrichtung nach Anspruch 1, bei der die Einstellmittel Mittel zum Einstellen des Stroms durch den ersten Abschnitt umfassen.

4. Vorrichtung nach Anspruch 1, mit des weiteren einem dritten Resonatorabschnitt, der an einen der anderen der Abschnitte optisch gekoppelt ist.

5. Vorrichtung nach Anspruch 4, bei der der dritte Abschnitt einen Photodetektor bildet.

6. Vorrichtung nach Anspruch 5, und des weiteren mit Mitteln, die zwischen dem dritten Abschnitt und den ersten und zweiten Abschnitten geschaltet sind, um die Ausgangsstrahlung aus den ersten und zweiten Abschnitten zu steuern.

7. Vorrichtung nach Anspruch 3, mit ersten Mitteln zum Vorspannen des ersten Abschnittes mit einem gepulsten Strom und mit zweiten Mitteln zum Vorspannen des zweiten Abschnittes mit einem gepulsten Strom.

8. Vorrichtung nach Anspruch 7, und des weiteren mit Photodetektormittel zum Nachweis der optischen Ausgangsstrahlung von wenigstens einem Abschnitt.

9. Vorrichtung nach Anspruch 8, bei der die Detektormittel wellenlängenempfindlich sind.

10. Vorrichtung nach Anspruch 1, bei der die Abschnitte gegeneinander um eine durch die aktive Schichten gebildete Achse verdreht sind.

11. Vorrichtung nach Anspruch 1, und des weiteren mit einem äußeren optischen Resonator, wobei die ersten und zweiten Abschnitte optisch gegenüber dem äußeren optischen Resonator ausgerichtet sind.

12. Vorrichtung nach Anspruch 1, bei der wenigstens eine der Spiegelflächen mit einer Dünnschicht beschichtet ist.

13. Vorrichtung nach Anspruch 3, bei der die Einstellmittel Mittel zum Einstellen der Vorspannung umfassen.

14. Vorrichtung nach Anspruch 3, mit Mitteln zum Messen wenigstens einer Eigenschaft der Ausgangsstrahlung von einem der Abschnitte bezüglich des durch einen der Abschnitte fließenden Stroms und mit Rückkopplungsmitteln, die die wenigstens eine Eigenschaft zum Halten der Ausgangsstrahlung bei einem gewünschten Spektralwert verwenden.

15. Vorrichtung nach Anspruch 14, bei der die wenigstens eine Eigenschaft die erste Ableitung der Lichtausgangsintensität bezüglich des Stroms durch jenen Abschnitt umfaßt.

16. Vorrichtung nach Anspruch 15, bei der die Rückkopplungsmittel die erste Ableitung bei einem Wert von annähernd Null halten.

17. Vorrichtung nach Anspruch 16, bei der die Rückkopplungsmittel den Wert von annähernd Null bei einem lokalen Maximum in der Kennlinie von Lichtausgangsleistung über dem Strom durch den einen Abschnitt halten.

18. Vorrichtung nach Anspruch 17, und mit des weiteren Mitteln zum Überlagern eines Modulationsstromes durch den einen Abschnitt.

19. Vorrichtung nach Anspruch 14, bei der die wenigstens eine Eigenschaft die Lichtausgangsintensität umfaßt.

20. Vorrichtung nach Anspruch 19, bei der die Rückkopplungsmittel die Eigenschaft bei einem lokalen Maximum der Kennlinie von Lichtausgangsleistung über dem Strom durch den einen Abschnitt halten.

## Revendications

1. Un dispositif optique à semiconducteurs destiné à produire une émission de rayonnement à un seul mode, comprenant des première (3) et seconde (5) sections de diodes à semiconducteurs à guidage par indice qui sont mutuellement espacées, l'une au moins de ces sections de diodes étant une section de diode laser, chacune des couches actives de guidage d'onde (11, 13; 33, 53) des sections de diodes ayant une largeur inférieure à 20 µm et étant couplée de façon suffisamment serrée pour procurer une sélectivité de mode accrue, caractérisé en ce que les sections sont couplées ensemble au point de vue optique par l'intermédiaire de surfaces de miroir clivées, et des moyens ($I_1$, $I_2$) sont prévus pour régler l'indice de réfraction de chaque section par rapport à l'autre.

2. Un dispositif selon la revendication 1, comprenant des moyens pour changer la longueur d'onde de l'émission de rayonnement.

3. Un dispositif selon la revendication 1, dans lequel les moyens de réglage comprennent des moyens pour régler le courant qui circule dans la première section.

4. Un dispositif selon la revendication 1, comprenant en outre une troisième section de cavité en couplage optique avec l'une des autres sections.

5. Un dispositif selon la revendication 4, dans lequel la troisième section constitue un photodétecteur.

6. Un dispositif selon la revendication 5, comprenant en outre des moyens intercalés entre la troisième section et les première et seconde sections pour commander l'émission des première et seconde sections.

7. Un dispositif selon la revendication 3, comprenant des premiers moyens pour polariser la première section avec un courant pulsé, et des seconds moyens pour polariser la seconde section avec un courant pulsé.

8. Un dispositif selon la revendication 7, comprenant en outre des moyens photodétecteurs pour détecter l'émission optique d'au moins une section.

9. Un dispositif selon la revendication 8, dans lequel les moyens détecteurs sont sensibles à la longueur d'onde.

10. Un dispositif selon la revendication 1, dans lequel les sections sont disposées de façon à présenter une torsion mutuelle autour d'un axe qui est défini par les couches actives.

11. Un dispositif selon la revendication 1, comprenant en outre une cavité optique externe, et les première et seconde sections se trouvent à l'intérieur de la cavité optique externe et sont alignées de façon optique par rapport à cette cavité.

12. Un dispositif selon la revendication 1, dans lequel l'une au moins des surfaces de miroir est revêtue d'une couche mince.

13. Un dispositif selon la revendication 3, dans lequel les moyens de réglage comprennent des moyens pour régler la polarisation.

14. Un dispositif selon la revendication 3, comprenant des moyens pour mesurer au moins une caractéristique de l'émission de l'une des sections, par rapport au courant qui circule dans l'une des sections; et des moyens de rétroaction qui utilisent cette caractéristique ou ces caractéristiques pour maintenir l'émission à la valeur spectrale désirée.

15. Un dispositif selon la revendication 14, dans lequel la ou les caractéristiques précitées correspondent à la dérivée première de l'intensité d'émission lumineuse par rapport au courant qui circule dans la section considérée.

16. Un dispositif selon la revendication 15, dans lequel les moyens de rétroaction maintiennent la dérivée première à une valeur approximativement égale à zéro.

17. Un dispositif selon la revendication 16, dans lequel les moyens de rétroaction maintiennent la valeur approximativement égale à zéro à un maximum local de la courbe caractéristique de puissance d'émission lumineuse en fonction du courant d'une section.

18. Un dispositif selon la revendication 17, comprenant en outre des moyens pour superposer un courant de modulation dans la section considérée.

19. Un dispositif selon la revendication 14, dans lequel la ou les caractéristiques correspondent à l'intensité d'émission lumineuse.

20. Un dispositif selon la revendication 19, dans lequel les moyens de rétroaction maintiennent la caractéristique précitée à un maximum local de la courbe caractéristique de puissance d'émission lumineux en fonction du courant d'une section.

## FIG. 1

## FIG. 2

*FIG. 3*

101

170

110          110

*FIG. 4*

170

110

70        70        70

*FIG. 5*

170

110

*FIG. 6*

170          91

110          71

FIG. 7

FIG. 8

FIG. 9

FIG. 10

3

## FIG. 12

|← 125Å →|

I₂(mA)

I₂(mA)

25.0 ———————— 20

17.0 ———————— 15

13.5 ———————— 12

10.5 ———————— 8.6

7.4 ———————— 6.0

13,050Å

## FIG. 11

|← 125Å →|

5.0 ————————

4.0 ————————

3.0 ————————

2.0 ————————

1.5 ————————

1.0 ————————

0.5 ————————

0⁺ns ————————

1.3 μm

## FIG. 15

320    321    322

327

301    312    302    303

311    313

323

FIG. 13

FIG. 14

FIG. 16

FIG. 17

## FIG. 18

OUTPUT POWER
(ARB. UNITS)

$I_L = 50$ mA

$I_L = 40$ mA

$I_L = 30$ mA

MODULATOR CURRENT (mA)

## FIG.19

## FIG. 20

## FIG. 21

# FIG. 22

# FIG. 23